# EUROPÄISCHE PATENTSCHRIFT

(11) **EP 2 263 432 B1**
(45) Veröffentlichungstag und Bekanntmachung des Hinweises auf die Patenterteilung: **21.09.2011**
(21) Anmeldenummer: 09721150.2
(22) Anmeldetag: 11.03.2009
(51) Int. Cl.: H05K 7/20, H05K 5/00, H01R 9/22, H01L 31/048

(54) **VERBINDUNGSBOX FÜR SOLAR-MODULE**
JUNCTION BOX FOR SOLAR MODULES
BOÎTE DE JONCTION POUR MODULES SOLAIRES

(30) Priorität: 13.03.2008 DE 102008013930; 06.05.2008 DE 102008022298
(43) Veröffentlichungstag der Anmeldung: 22.12.2010
(73) Patentinhaber: FPE Fischer Gmbh, 88299 Leutkirch (DE)
(72) Erfinder: PFEFFER, Roland, 88299 Leutkirch (DE)
(74) Vertreter: Kaufmann, Sigfrid
(86) Internationale Anmeldenummer: PCT/DE2009/000330
(87) Internationale Veröffentlichungsnummer: WO 2009/112018

(56) Entgegenhaltungen:
- DE-B3-102006 027 104
- DE-C1- 10 050 614
- DE-T5-112005 002 898

## Beschreibung

Die Erfindung betrifft eine Verbindungsbox, mit der die in den Bypassdioden, MOSFETs oder entsprechenden Leistungshalbleitern eines Solar-Moduls erzeugte Wärme gut abgeleitet wird.

Beim Betrieb von Solaranlagen lässt sich die Abschattung einzelner Solarzellen, z. B. durch Wolken oder herabfallendes Laub, nie vollständig vermeiden. Ohne Schutzmaßnahmen entstünde in der abgeschatteten Solarzelle durch den so genannten Zener-Effekt eine hohe Verlustleistung, die zu einem "Hot Spot" in der Zelle und damit fast immer zu deren Zerstörung führt.

Aus diesem Grund werden üblicherweise den Solarzellen bzw. den Reihenschaltungen von Solarzellen elektronische Bauteile, wie Bypassdioden, MOSFETs oder vergleichbare Leistungshalbleiter parallel geschaltet. Bei einer Abschattung wird die jeweilige Zelle bzw. Zellenreihe durch das elektronische Bauteil gebrückt, wodurch sichergestellt wird, dass der von den nicht beschatteten Zellen erzeugte Strom weiterhin fließt, ohne dass jedoch dabei die Gefahr der Zerstörung von Solarzellen besteht.

Im Falle der Abschattung von Solarzellen müssen solche elektronischen Bauteile große Leistungen aufnehmen. Dies führt dazu, dass sich diese ohne ausreichende Kühlung stark erwärmen, wodurch ihre Lebensdauer nachhaltig verringert wird. Im Extremfall kann dies auch zu einer sofortigen Zerstörung der Bauteile führen.

Die elektronischen Bauteile werden üblicherweise in den Verbindungsboxen, die dem Verschalten der einzelnen Solar-Module dienen, untergebracht. Hierzu werden oft noch Verbindungsboxen aus Kunststoff (u.a. DE 203 11 184 U1, DE 11 2005 002 898 T5 und EP 1 102 354 A2) eingesetzt, die die Wärme allerdings nur sehr schlecht ableiten.

In DE 10 2004 010 658 A1 wird vorgeschlagen, die Verbindungsbox mit Silikonharz, dass eine vergleichsweise gute Wärmeleitfähigkeit hat, auszugießen und den Deckel der Box als eine mit wetterbeständigem Harz beschichtete Metallplatte auszuführen. Die Wärmeabgabe ist jedoch nach wie vor ungenügend. Hinzu kommt, dass defekte Bauteile praktisch nicht ausgetauscht werden können.

Da Solaranlagen immer zahlreicher eingesetzt werden, steigt auch die Nachfrage an Verbindungsboxen. Parallel steigen die Anforderungen an die Qualität der Boxen; hinzu kommt ein wachsender Kostendruck infolge EEG-Degression. Außerdem geht der Trend zu immer leistungsfähigeren Solar-Modulen, bei denen Sperrströme von 8 ... 16 A auftreten. Die marktüblichen Boxen sind bislang jedoch meist nur für Ströme bis höchstens 8 A ausgelegt.

Aus dem Stand der Technik sind deshalb neuerdings Verbindungsboxen, die eine verbesserte Entwärmung der elektronischen Bauteile gewährleisten, bekannt (u. a. DE 100 50 614 C1, WO 2006/117895 A1, US 7,288,717 B1 und DE 10 2004 036 697 A1).

In DE 10 2006 027 104 B3 wird eine Verbindungsbox beschrieben, bei der die elektronischen Bauteile durch Druckelemente, wie z.B. Federbügel in Aussparungen im Gehäuse, die der Geometrie der Bauteile entsprechen, gepresst werden. Dabei befindet sich zwischen dem Gehäuse und den Bauteilen eine elektrische Isolation, vorzugsweise ein thermisch leitender Silikongummi.

In DE 10 2005 022 226 A1 wird eine Anordnung zur Wärmeabfuhr in einem Gehäuse angeordneter elektronischer Bauteile (z.B. Anschlussdose für Photovoltaikmodule) offenbart, bei der eine mit einem Kühlkörper versehene Verschlussplatte auf die wärmebelasteten Bauteile gepresst wird. Der Kühlkörper ist ein Strangpressprofil aus Aluminium, das Gehäuseunterteil aus Kunststoff-Spritzguss. Zwar wird hier lediglich der Kühlkörper am Deckel zu Entwärmung eingesetzt - da Strangpressprofile jedoch eine deutlich höhere Wärmeleitfähigkeit und damit Kühlwirkung als gegossenes Aluminium haben, wird dieser Nachteil weit gehend kompensiert. Die verbesserte Kühlwirkung von Kühlkörpern oder Gehäusen aus Aluminium-Strangpressprofilen wird unter anderem auch in DE 102 49 436 A1 und US 6,374,912 B1 genutzt.

Mit beiden Lösungen wird eine verbesserte Entwärmung erreicht. Auch die elektrische Isolation der Bauteile gegenüber dem Gehäuse ist sichergestellt. Es wird jedoch von einem kastenförmigen Gehäuse ausgegangen, bei dem die Bauteile in Aussparungen, die sich in den Seitenwänden befinden, bzw. gegen den Gehäusedeckel gepresst werden. Dieser kompakte Aufbau bewirkt eine schlechtere Entwärmung der Bauteile, als ein Aufbau, bei dem das Gehäuse derart von der Kastenform abweicht, dass ein größeres Verhältnis Oberfläche zu Volumen erreicht wird.

Der Erfindung liegt die Aufgabe zugrunde, eine Verbindungsbox zu schaffen, die eine verbesserte Entwärmung der elektrischen Bauteile gewährleistet.

Diese Aufgabe wird erfindungsgemäß durch die kennzeichnenden Merkmale des Anspruches 1 gelöst. Weitere vorteilhafte Ausführungen ergeben sich aus den Ansprüchen 2 bis 11.

Die Verbindungsbox für Solar-Module umfasst ein Gehäuse, das aus einem Grundkörper und einem auf diesem aufgebrachten Gehäusedeckel besteht. Im Gehäuse der Verbindungsbox befinden sich elektrische Bauteile und elektrische Verbindungen. Nach Maßgabe der Erfindung ist zumindest an einer Seitenwand des Grundkörpers zumindest eine Aufnahmekammer angeordnet, die distal aus der Seitenwand auskragt. In der zumindest einer Aufnahmekammer ist zumindest ein mit einer Isolierhülle ummanteltes elektrisches Bauteil eingebracht, das an den Innenseiten der Aufnahmekammer sowie am Deckel fest anliegt.

Dabei ist vorgesehen, dass mindestens ein elektrisches Bauteil ein elektronisches Bauteil, wie z.B. eine Diode, ein MOSFET oder ein anderer Leistungshalbleiter, ist, das dem Schutz der Solarmodule dient. Üblicherweise sind zu diesem Zweck Bypassdioden oder Bypass-MOSFETs eingesetzt.

Durch diese Verlagerung der elektrischen Bauteile nach außen wird eine nachhaltig verbesserte Kühlung der Bauteile bewirkt. Außerdem erwärmt sich der Grundkörper, der üblicherweise auf den Rückseiten der Solar-Module befestigt wird, beim Betrieb weniger stark, wodurch eine übermäßige Erwärmung der Solar-Module vermieden wird.

Die Isolierhüllen bestehen bevorzugt aus Silikongummi. Ihre Dicke bewegt sich üblicherweise im Millimeterbereich, wodurch eine hochspannungsfeste Isolation erreicht wird. Durch die Verwendung des Silikongummis wird zudem eine gleichmäßige Druckverteilung und eine gute thermische Anbindung gesichert. Auf Montagehilfen wie Clips oder Klammern kann verzichtet werden.

Der Gehäusedeckel besteht aus stranggepresstem Aluminium und weist mehrere Kühlrippen auf. Es hat sich gezeigt, dass Teile aus Aluminium, die durch Strangpressen hergestellt wurden, eine ca. dreimal größere Wärmeleitfähigkeit besitzen als adäquate Teile aus Aluminiumdruckguss.

Vorteilhafterweise ist der Gehäusedeckel so groß, dass er über die Kontur des Grundkörpers übersteht. Damit wird die Kühlwirkung des Deckels erhöht, da im Bereich des Überstands beide Seiten des Deckels von kühlerer Luft angeströmt werden; des Weiteren wird die Strömungsdynamik der kühlenden Luft durch die Ausbildung eines Kamineffektes verbessert. Der übergroße Gehäusedeckel sorgt zudem für einen verbesserten Schutz der Kabeldurchführungen und Klebestellen vor mechanischen Einwirkungen.

üblicherweise sind drei oder vier elektrische Bauteile (Bypass-Dioden oder Bypass-MOSFETS) in einer Verbindungsbox untergebracht. Der Trend geht jedoch zu leistungsfähigeren Solar-Modulen, sodass in Zukunft möglicherweise die Anzahl der elektrischen Bauteile, die pro Box untergebracht werden müssen, zunehmen wird, was in der erfindungsgemäßen Verbindungsbox ohne Weiteres möglich ist.

Die erfindungsgemäße Verbindungsbox wird nachfolgend anhand eines Ausführungsbeispiels näher erläutert; hierzu zeigen:

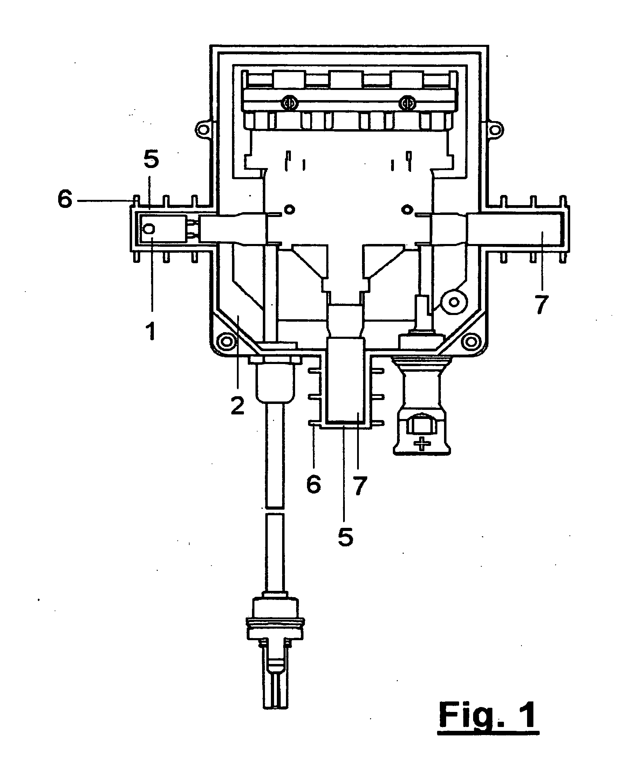

- Fig. 1:: die geöffnete Verbindungsbox in Draufsicht,
- Fig. 2:: die geöffnete Verbindungsbox in perspektivischer Ansicht mit Kunst- stoffhaube,
- Fig. 3:: die geschlossene Verbindungsbox in perspektivischer Ansicht.

Die Verbindungsbox besteht aus dem aus Aluminiumdruckguss hergestellten Grundkörper 2, bei dem an drei Seitenwänden je eine balkonartig geformte Aufnahmekammer 5 distal auskragt. Die elektrischen Bauteile, hier Bypassdioden 1, sind mit der Isolierhülle 7 aus thermisch leitendem Silikongummi umgeben und liegen an den Innenseiten der Aufnahmekammer sowie am Gehäusedeckel 3 fest an. Die drei Aufnahmekammern 5 sind mit den Kühlkörperrippen 6 versehen.

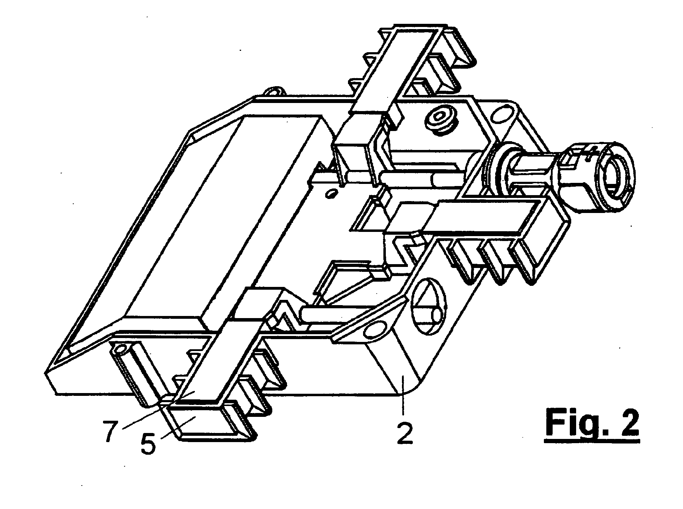

Wie aus Fig. 2 ersichtlich, sind die Böden der Aufnahmekammern 5 gegenüber dem Boden des Grundkörpers angehoben, was der Geometrie der Dioden 1 geschuldet ist und im Übrigen eine verbesserte Kühlung der Dioden 1 zur Folge hat.

Die Isolierhüllen 7 sind ca. 1 mm dick, sodass die Bypassdioden gegen Überspannungsschäden geschützt sind. Sie wirken gleichzeitig als Wärmeleitfolie.

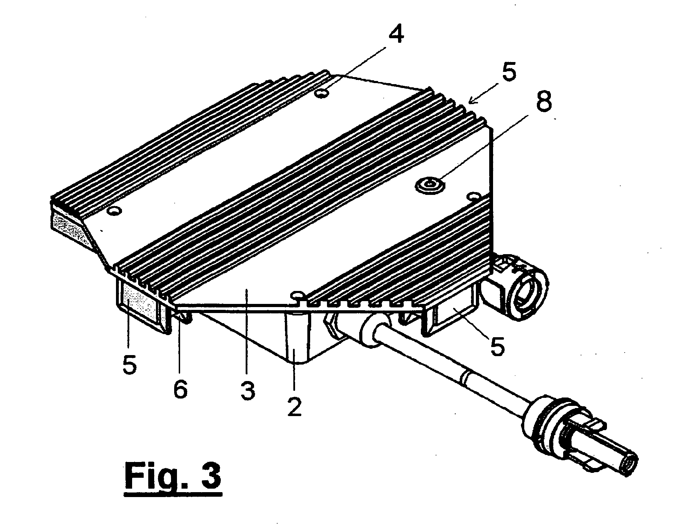

Wie aus Fig. 3 zu ersehen ist, bedeckt der mit Kühlrippen versehene und mit vier Schrauben 4 auf dem Grundkörper 2 angebrachte Gehäusedeckel 3 aus extrudiertem Aluminium die drei Aufnahmekammern 5 vollständig und ragt an mehreren Stellen deutlich über die Kontur des Grundkörpers 2 hinaus. Im Bereich des Überstands wirkt der Gehäusedeckel als doppelseitiger Kühlkörper. Außerdem wird durch den auftretenden Kamineffekt eine bessere Anströmung des Gehäusedeckels 3 erzielt. Aufgrund der verbesserten Kühlung kann die Verbindungsbox für Anlagen mit Bypassströmen von bis zu 16 A und mehr verwendet werden. Ggf. können hierfür auch vier oder mehr Bypassdioden in weiteren Aufnahmekammern untergebracht werden.

Um einen ausreichenden Druckausgleich der Verbindungsbox zu gewährleisten, ist in dem Gehäusedeckel 3 die wasserdichte, jedoch luftdurchlässige Membran aus Vliesverbundstoff 8 eingebracht.

### Liste der verwendeten Bezugszeichen

- 1: Bypassdiode/elektrisches Bauteil
- 2: Grundkörper
- 3: Gehäusedeckel
- 4: Schraube
- 5: Aufnahmekammer
- 6: Kühlrippe
- 7: Isolierhülle
- 8: Membran aus Vliesverbundstoff

## Patentansprüche

1. Verbindungsbox für Solar-Module, mit einem Gehäuse (2, 3), das aus einem Grundkörper (2) und einem auf diesem aufgebrachten Gehäusedeckel (3) besteht, wobei in dem Gehäuse elektrische Bauteile (1) und elektrische Verbindungen angeordnet sind, **dadurch gekennzeichnet, dass** zumindest an einer Seitenwand des Grundkörpers (2) zumindest eine Aufnahmekammer (5) angeordnet ist, die distal aus der Seitenwand auskragt, zumindest ein elektrisches Bauteil (1) mit einer Isolierhülle (7) ummantelt ist, wobei das zumindest eine mit der Isolierhülle (7) ummantelte elektrische Bauteil (1) in der Aufnahmekammer (5) angeordnet ist und an den Innenseiten der Aufnahmekammer (5) sowie am Deckel (3) fest anliegt.

2. Verbindungsbox nach Anspruch 1, **dadurch gekennzeichnet, dass** das an zumindest einer Außenseite mindestens einer Aufnahmekammer (5) Kühlrippen (6) ausgebildet sind.

3. Verbindungsbox nach Anspruch 1 oder 2, **dadurch gekennzeichnet, dass** der Gehäusedeckel (3) aus Aluminium besteht und die Oberfläche vergrößernde Strukturen zum Verbessern der Wärmeabgabe, z. B. Kühlrippen, aufweist.

4. Verbindungsbox nach Anspruch 3, **dadurch gekennzeichnet, dass** der Gehäusedeckel (3) stranggepresst ist.

5. Verbindungsbox nach Anspruch 1 bis 4, **dadurch gekennzeichnet, dass** der Gehäusedeckel (3) über die Kontur des Grundkörpers (2) übersteht.

6. Verbindungsbox nach einem der Ansprüche 1 bis 5, **dadurch gekennzeichnet, dass** das zumindest ein elektrisches Bauteil (1) eine elektronische Bauteil ist.

7. Verbindungsbox nach Anspruch 6, **dadurch gekennzeichnet, dass** das elektronische Bauteil ein Leistungshalbleiter ist.

8. Verbindungsbox nach Anspruch 7, **dadurch gekennzeichnet, dass** der Leistungshalbleiter ein MOSFET oder eine Diode ist.

9. Verbindungsbox nach Anspruch 8, **dadurch gekennzeichnet, dass** die Diode eine Bypassdiode oder der MOSFET ein Bypass-MOSFET ist.

10. Verbindungsbox nach einem der Ansprüche 1 bis 9, **dadurch gekennzeichnet, dass** die Isolierhülle (7) aus einem gut Wärme leitenden Material besteht.

11. Verbindungsbox nach Anspruch 10, **dadurch gekennzeichnet, dass** das gut Wärme leitende Material Silikongummi ist.

## Claims

1. A junction box for solar modules with a housing (2, 3) comprising a housing body (2) and a housing cover (3) applied to said body, electrical components (1) and electrical connections being arranged in said housing, **characterised in that** at least one mounting recess (5) is provided in at least one side wall of the housing body (2), projecting distally from said side wall, and at least one electrical component (1) is sheathed in an isolating covering (7), at least one electrical component (1) sheathed in an isolating covering (7) being arranged in the mounting recess (5) and in firm contact with the inner walls of the mounting recess (5) and the cover (3).

2. A junction box according to Claim 1, **characterised in that** cooling fins (6) are formed on at least one outer side of at least one mounting recess (5).

3. A junction box according to Claim 1 or 2, **characterised in that** the housing cover (3) is of aluminium and the surface displays enlarging structures to improve heat dissipation, for example cooling fins.

4. A junction box according to Claim 3, **characterised in that** the housing cover (3) is extruded.

5. A junction box according to Claims 1 to 4, **characterised in that** the housing cover (3) projects beyond the contour of the housing body (2).

6. A junction box according to one of the Claims 1 to 5, **characterised in that** at least one electrical component (1) is an electronic component.

7. A junction box according to Claim 6, **characterised in that** the electronic component is a power semiconductor.

8. A junction box according to Claim 7, **characterised in that** the power semiconductor is a MOSFET or a diode.

9. A junction box according to Claim 8, **characterised in that** the diode is a bypass diode or the MOSFET a bypass MOSFET.

10. A junction box according to one of the Claims 1 to 9, **characterised in that** the isolating covering (7) comprises a material with good thermal conductivity.

11. A junction box according to Claim 10, **characterised in that** the material with good thermal conductivity is silicone rubber.

## Revendications

1. Boîte de connexion pour module solaire, comportant un boîtier (2, 3) constitué d'un corps principal (2) et d'un couvercle de boîtier (3) placé sur celui-ci, le boîtier abritant des composants électriques (1) et des connexions électriques, **caractérisée en ce qu'**au moins un compartiment (5) est placé sur au moins une des parois latérales du corps principal (2) et dépasse distalement de cette paroi latérale, qu'au moins un composant électrique (1) est muni d'une enveloppe isolante (7), le ou les composants électriques (1) munis d'une enveloppe isolante (7) étant placés dans le compartiment (5) et fixés aux faces intérieures du compartiment (5) et du couvercle (3).

2. Boîte de connexion selon la revendication 1, **caractérisée en ce qu'**au moins une des faces extérieures d'au moins un compartiment (5) comporte des ailettes de refroidissement (6).

3. Boîte de connexion selon la revendication 1 ou 2, **caractérisée en ce que** le couvercle de boîtier (3) est constitué d'aluminium et que la surface comporte des structures, telles que des ailettes de refroidissement, agrandissant la surface pour améliorer la dissipation de chaleur.

4. Boîte de connexion selon la revendication 3, **caractérisée en ce que** le couvercle de boîtier (3) est extrudé.

5. Boîte de connexion selon les revendications 1 à 4, **caractérisée en ce que** le couvercle de boîtier (3) dépasse du contour du corps principal (2).

6. Boîte de connexion selon l'une des revendications 1 à 5, **caractérisée en ce qu'**au moins un composant électrique (1) est un composant électronique.

7. Boîte de connexion selon la revendication 6, **caractérisée en ce que** le composant électronique est un semi-conducteur de puissance.

8. Boîte de connexion selon la revendication 7, **caractérisée en ce que** le semi-conducteur de puissance est un MOSFET ou une diode.

9. Boîte de connexion selon la revendication 8, **caractérisée en ce que** la diode est une diode by-pass ou que le MOSFET est un MOSFET by-pass.

10. Boîte de connexion selon l'une des revendications 1 à 9, **caractérisée en ce que** l'enveloppe isolante (7) est composée d'un matériau possédant une bonne conductibilité thermique.

11. Boîte de connexion selon la revendication 10, **caractérisée en ce que** le matériau possédant une bonne conductibilité thermique est un caoutchouc de silicone.
